(19) Europäisches Patentamt / European Patent Office / Office européen des brevets

(11) **EP 3 202 624 A1**

(12) **EUROPEAN PATENT APPLICATION**
published in accordance with Art. 153(4) EPC

(43) Date of publication:
**09.08.2017 Bulletin 2017/32**

(21) Application number: **15846338.0**

(22) Date of filing: **07.08.2015**

(51) Int Cl.:
**B60R 16/02** *(2006.01)*    **H01L 21/822** *(2006.01)*
**H01L 27/04** *(2006.01)*

(86) International application number:
**PCT/JP2015/072440**

(87) International publication number:
**WO 2016/051959 (07.04.2016 Gazette 2016/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **29.09.2014 JP 2014197756**

(71) Applicant: **Hitachi Automotive Systems, Ltd.**
**Hitachinaka-shi, Ibaraki 312-8503 (JP)**

(72) Inventors:
- **IWASAWA Hiroshi**
  **Tokyo 100-8280 (JP)**
- **HIROTSU Teppei**
  **Tokyo 100-8280 (JP)**
- **ISHIDA Ryosuke**
  **Hitachinaka-shi**
  **Ibaraki 312-8503 (JP)**

(74) Representative: **MERH-IP Matias Erny Reichl Hoffmann**
**Patentanwälte PartG mbB**
**Paul-Heyse-Strasse 29**
**80336 München (DE)**

(54) **ELECTRONIC CONTROL DEVICE**

(57)    The purpose of the present invention is to provide an electronic control device including an integratable protection circuit that is capable of protecting an internal circuit, a sensor, etc., against both of surge voltage application and battery connection abnormality. The electronic control device includes an input terminal connectable to an external sensor and switch, and a power supply wiring and a GND wiring that are utilized to supply power to the internal circuit, wherein protection elements each including a PN junction are connected between the input terminal and the power supply wiring or the GND wiring, and protection resistor are further connected in series between the protection elements and the power supply wiring or the GND wiring.

FIG. 6

Printed by Jouve, 75001 PARIS (FR)

EP 3 202 624 A1

**Description**

Technical Field

The present invention relates to an electronic control device which controls an engine or the like of an automobile, and in particular, to an electronic control device provided with the protection means for protecting an internal circuit, the sensors or the like from a surge or battery connection abnormality, with regard to a path of a signal inputted into the electronic control device from various kinds of sensors or operation switches (hereinafter referred to as sensor (s) or the like) mounted on a controlled object.

Background Art

In recent years, high performance of an automobile is remarkable, and accordingly the number of electronic control devices mounted on a vehicle is increasing. Meanwhile, the space which can be allotted to an electronic control device is decreasing for improving fuel economy by a weight reduction, and securing the interior space. The demand for reducing the size of the electronic control device has become strong.

For methods of miniaturizing the electronic control device, one effective way is to integrate elements mounted on a printed circuit board as individual elements into an integrated circuit (IC). Since, in particular, a protection circuit with above-mentioned resistors and capacitors has tens of input terminals and each of the terminals is to be mounted on the circuit, a considerable printed circuit board area is needed for the mounting. Thus, the miniaturization effect by integrating the circuit is large.

However, in cases where this protection circuit is integrated, there is the problem that integration of capacitors is difficult due to the following reasons. That is, the capacitors used for the above-mentioned conventional protection circuit need a capacitance value (for example, several dozens of nF to several hundreds of nF) that is equal to or larger than a certain value in order to absorb surge energy. However, in order to achieve such a capacitor of large capacity within an IC, a very large chip area is needed, and the large capacitor is not well suited in cost as compared with the merit of the miniaturization by integration.

A known protection circuit coping with this problem is, for example, a protection circuit which has a diode between an input terminal and a power supply/GND as shown in the FIG. 8 of PTL 1. Use of the diode in the protection circuit allows the circuit itself not to absorb surge energy, but allows the surge energy to be released to a power supply/GND, and surge energy withstand needed for the diode itself can be suppressed. Since the surge energy withstand of an element is generally proportional to the area of a chip, the chip area needed for a protection circuit can be suppressed, and thus cost can be suppressed.

As a similar configuration, the method of using a ggMOS (grounded gate metal oxide semiconductor transistor) or a thyristor structure instead of the diode is also generally used. Common for a protection circuit using these elements including diodes is that the protection circuit operates such that normally, the PN junction in each element is reversely biased, and when a surge is applied, the PN junction is forward biased, or the MOS structure or the thyristor structure is turned on and thus the surge is released to a power supply or GND, or is absorbed.

Although these protection circuit methods are effective against a surge application, they cannot cope with the negative voltage application due to battery connection abnormality. That is, if a Vb power supply with reversed polarity is applied to an input terminal through the sensors or the like, it is not possible to prevent large current from flowing into the input terminal from the GND.

Citation List

Patent Literature

PTL 1: JP 2013-3072076 A

Summary of Invention

Technical Problem

The object of the present invention is to provide an electronic control device including a protection circuit that can be integrated and is capable of protecting an internal circuit, and sensors or the like against both surge application and battery connection abnormality.

Solution to Problem

An electronic control device includes: an input terminal connectable with an external sensor or an external switch; and a power supply wiring and a GND wiring used for supplying power to an internal circuit, wherein a protection element including a PN junction is connected between the input terminal and the power supply wiring or the GND wiring, and a protection resistor is further connected in series between the protection element and the power supply wiring or the GND wiring.

Advantageous Effects of Invention

According to the present invention, an electronic control device including a protection circuit that can be integrated and is capable of protecting an internal circuit, and the sensors or the like against both surge application and battery connection abnormality can be provided.

Brief Description of the Drawings

[FIG. 1] FIG. 1 is a circuit block diagram showing a general circuit configuration of an electronic control device, and sensors or the like.
[FIG. 2] FIG. 2 is a diagram showing influence when a surge is applied to the electronic control device shown in FIG. 1.
[FIG. 3] FIG. 3 is a diagram showing influence of battery connection abnormality occurring in the electronic control device shown in FIG. 1.
[FIG. 4] FIG. 4 is a circuit block diagram showing an example of a configuration of a protection circuit used in a conventional electronic control device.
[FIG. 5] FIG. 5 is a circuit block diagram showing a configuration when a conventional integrated protection circuit is applied to an electronic control device.
[FIG. 6] FIG. 6 is a circuit block diagram showing a configuration of an electronic control device 1 according to a first embodiment.
[FIG. 7] FIG. 7 is a diagram showing an example of surge application conditions due to static electricity.
[FIG. 8] FIG. 8 is a view showing a section structure of an integrated protection circuit 41 in a mounting method in the first embodiment.
[FIG. 9] FIG. 9 is a view showing a section structure of an integrated protection circuit 41 in a mounting method in the first embodiment.
[FIG. 10] FIG. 10 is a circuit block diagram showing a configuration of the electronic control device 1 according to a second embodiment.

Description of Embodiments

[Outline of electronic control device]

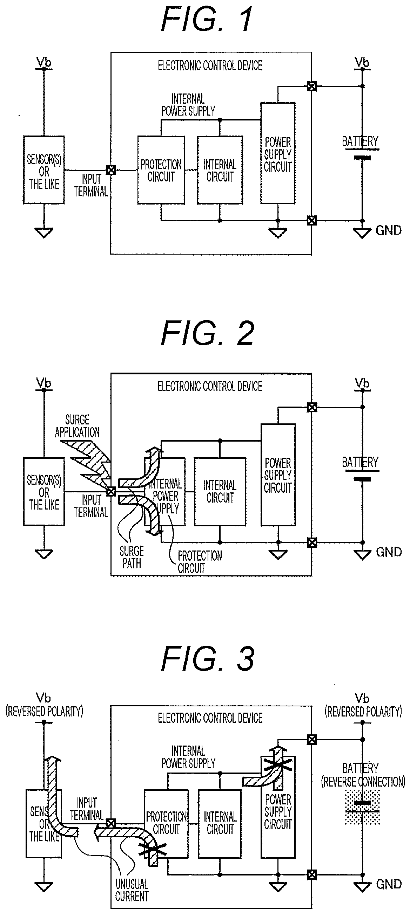

Conventionally, as means to highly control an engine of a car or the like, an electronic control device is used which achieves a desired control of a state of a controlled object such as engine or the like from various sensors or the like connected to the controlled object, such that an operation by a drive is inputted from an operation switch, and an actuator and the like which are mounted in the controlled object are operated according to calculated results by calculating means such as internal microcomputers and the like.
Such an electronic control device is provided with an input terminal, and the above mentioned sensors or the like are connected to this input terminal, and a predetermined signal is inputted. A general connection configuration of an electronic control device and the sensors or the like is shown in FIG. 1. Although FIG. 1 shows only one of the sensors or the like, and one corresponding input terminal due to space limitation, combinations of tens of sensors or the like and input terminals are practically mounted.
Generally, an electronic control device is configured such that a wiring (hereinafter referred to as Vb power supply) connected to positive potential of a battery (in many cases, lead battery of nominally 12 V) as the power supply and a wiring (hereinafter referred to as GND) connected to negative potential are connected, and an internal circuit operates by an low voltage internal power supply generated through an internal power supply circuit. While some of the sensors or the like operate by the internal power supply of the electronic control device (not shown), others, as illustrated in FIG. 1, are connected to the Vb power supply without using the electronic control device, and operate.

Abnormal input applied to electronic control device]

The above is an outline about the electronic control device. Not only the predetermined signal but also an abnormal input is sometimes applied to this input terminal. Although various cases can be considered as this abnormal input, surge application (FIG. 2) and battery connection abnormality (FIG. 3) are mainly listed.

[Surge application and its influence]

Surge application is an application of static electricity received from a human body and the like at the time of a vehicle assembly, maintenance and the like, impulse surge received from a nearby apparatus or the like through electromagnetic coupling and/or capacitive coupling at the time of operation and the like. Hereinafter, these are collectively referred to as "surge."

Meanwhile, inside an electronic control device, a circuit (hereinafter referred to as internal circuit) which is manufactured by micro processing technology and is not highly resistant to a surge as well as a microcomputer are used. If such an internal circuit is connected with the input terminal of the electronic control device directly, the internal circuit may be destroyed by the surge and a correct operation may not be possible.

[Surge protection by protection circuit]

In order to prevent this, it is common to have a protection circuit between the input/output terminal and the internal circuit. Even if the surge is applied to the input/output terminal, the protection circuit can prevent the internal circuit from being influenced, since, as shown in FIG. 2, the protection circuit allows the surge to be released to a power supply or GND or absorbs the surge.

[Battery connection abnormality and its influence]

Battery connection abnormality refers to a connection abnormality in which, for example, the battery used for a Vb power supply is connected reversely with respect to polarity at the time of maintenance and the like. In cases where such a connection abnormality arises, the Vb power supply serves as reversed polarity (negative voltage) relative to GND, and an unusual current tends to flow toward the Vb power supply from GND.

Various paths can be conceived for the path of this unusual current, as shown in FIG. 3. Generally, the unusual current in the path which passes through a power supply circuit is coped with so that it may be cut off within a power supply circuit, but it is necessary to take separate measures for the unusual current in the path which passes via an input terminal. In cases where the unusual current of the path which passes via the input terminal is not cut off, there is a possibility that the sensors or the like connected may be destroyed by large current. Even if the sensors or the like are not destroyed, when the protection circuit itself has been destroyed by burning or the like, protection will not be possible against the surge to be applied in another occasion.

[Battery connection abnormality protection by protection circuit]

In order to prevent battery connection abnormality, the above-mentioned protection circuit is generally provided with a function which cuts off the unusual current which passes via this input terminal. That is, even if the Vb power supply with reversed polarity is applied to an input/output terminal, since the protection circuit cuts off large current, influence on the sensors or the like connected can be prevented.

[Conventional protection circuit]

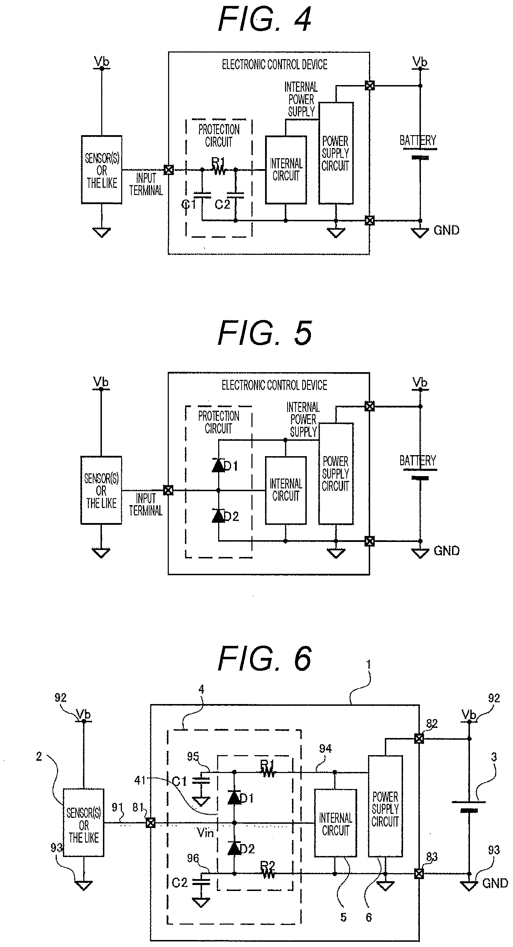

The above protection circuit is achievable by various methods. Conventionally, for example, the protection circuit using a resistor and two capacitors as shown in FIG. 4 has been used. This protection circuit absorbs the energy of surge by capacitors C1 and C2 when a surge is applied, and in the case of battery connection abnormality, R1 has a function which cuts off the unusual current from an internal circuit to an input terminal, and thus, the internal circuit, and the sensor or the like can be protected from a surge or battery connection abnormality by this protection circuit. Generally, these resistors and capacitors are mounted on a printed circuit board as individual elements. FIG. 5 is a circuit block diagram showing a configuration when a conventional integrated protection circuit is applied to an electronic control device. Hereinafter, embodiments according to the present invention are described with reference to drawings.

(First embodiment)

Hereinafter, an electronic control device according to the first embodiment of the present invention will be described with reference to FIG. 6. FIG. 6 is a circuit block diagram showing a configuration of an electronic control device 1 according to the first embodiment.

[Configuration of electronic control device 1]

In the electronic control device 1, a sensor or the like 2 is connected to an input terminal 81 through an input wiring 91, a positive electrode of a battery 3 is connected to a Vb power supply terminal 82 through a Vb power supply wiring 92, and a negative electrode of the battery 3 is connected to a GND terminal 83 through a GND wiring 93. The electronic control device 1 includes a protection circuit 4, an internal circuit 5, a power supply circuit 6, and an output circuit (not shown). The sensor or the like is connected to the Vb power supply wiring 92, the GND wiring 93, and the input wiring 91.

Protection circuit 4 includes diodes D1 and D2, protection resistors R1 and R2, and capacitors C1 and C2. The diode D1 and the protection resistor R1 are disposed in series between the input terminal 81 and an internal power supply 94. The diode D2 and the protection resistor R2 are disposed in series between the input terminal 81 and the GND wiring 93. A capacitor C1 is provided between a wiring 95 disposed between the diode D1 and the protection resistor R1, and the GND wiring 93. A capacitor C2 is provided between a wiring 96 disposed between the diode D2 and the protection resistor R2, and the GND wiring 93. The part surrounded by a broken line 49 is a part integrated in the integrated circuit (described later).

The internal circuit 5 includes a microcomputer and the like, and is connected to the input terminal 91, the internal power supply 94, the GND wiring 93, and an output circuit (not shown). The power supply circuit 6 is connected to the Vb power supply wiring 92, the GND wiring 93, and the internal power supply 94. The output circuit (not shown) is connected to an actuator (not shown) through the output terminal (not shown).

[Operation at the time of normal operation]

First, the operation of the electronic control device 1 and the protection circuit 4 at the time of normal operation is described. As described in the "Background Art", the role of the electronic control device 1 is to perform control calculation according to the state of the controlled object (not shown), and the input from a driver, and to achieve desired control through the actuator (not shown). In order to achieve this, the electronic control device 1 and the like performs the following operations.

The sensor or the like 2 outputs the signal according to the input from the state of a controlled object and a driver to the input wiring 91. The internal circuit 5 reads the signal from the input wiring 91 through the input terminal 81, carries out control calculation with an internal microcomputer or the like, drives the actuator through the output circuit (not shown), and performs desired control. In addition, the power supply circuit 6 generates, from the Vb power supply of the comparatively high voltage (around 14 [V]) obtained from Vb power supply wiring 92, the internal power supply of voltage (5 [V], 3.3 [V], etc.) suitable for operation of the internal circuit, and supplies electric power to the internal power supply wiring 94.

Here, protection circuit 4 does not perform a positive operation, but passes the signal from the input terminal 81, and transmits it to the internal circuit 5. This is because the protection circuit 4 does not interfere in the input signal in the normal state, and it is required to operate only in the case of abnormality to be described later to perform the protection operation.

Specifically, since the potential Vin of the input wiring 91 is between a GND potential and a potential Vcc of the internal power supply, the diodes D1 and D2 are reversely biased, and current does not flow during the normal operation. At the time of power turn-on, the capacitor C1 is charged/discharged to a potential Vcc of the internal power supply through the protection resistor R1, and the capacitor C2 is charged/discharged to a GND potential through the protection resistor R2. After the charge and discharge are completed, the state is stabilized, and current does not flow.

[Surge applied to electronic control device]

As described in the "Background Art", the applied surge includes static electricity received from a human body and the like, and impulse surge received from a nearby apparatus or the like through electromagnetic coupling and/or capacitive coupling, and has features in that although it is high voltage, but the duration is short, and the impedance of a surge source is comparatively high.

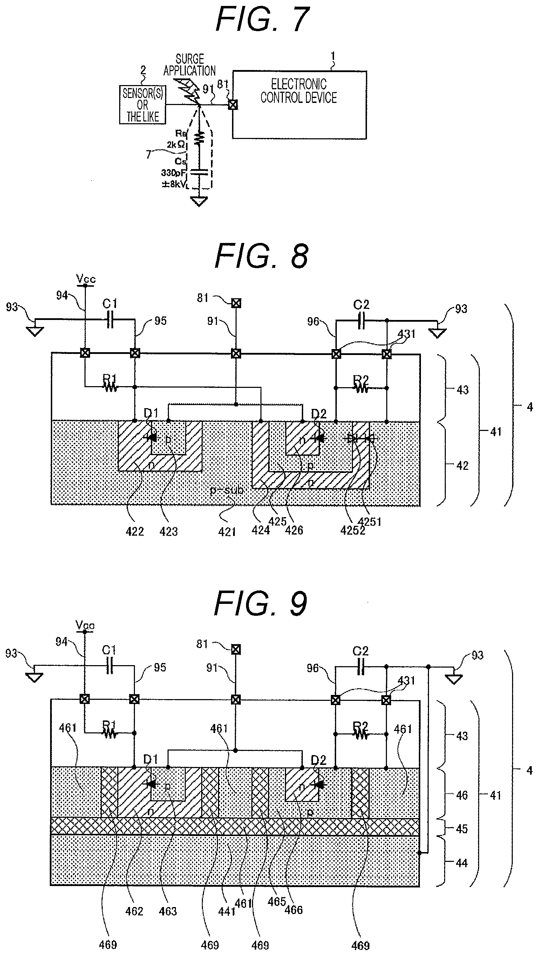

For example, in ISO 10605, which is an electrostatic test standard for automotive equipment, one of the static-electricity-application conditions which onboard equipment should bear is that the electric charge of a storage capacitor Cs with a capacity of 330 [pF] charged at ±8 [kV] is applied to the input wiring 91 or the input terminal 81 through discharging resistance Rs of resistance 2 [kΩ]. FIG. 7 shows the relationship between the surge source 7 and the electronic control device 1.

In cases where such a surge is applied, the protection circuit 4 in the electronic control device 1 protects the internal circuit 5 by releasing the surge to the internal power supply wiring 94 or the GND wiring 93. Since the operation at this time differs between when a surge of a positive voltage is applied and when a surge of a negative voltage is applied, each of them will be described below.

[Operation of protection circuit 4 when positive voltage surge is applied]

When the surge of a positive voltage is applied to the input terminal 81, a potential Vin of the input wiring 91 becomes higher than a potential Vcc of the internal power supply, the diode D1 is biased in the forward direction, surge current flows in the forward direction, and this surge current flows into the capacitor C1.

At this time, the potential Vin of the input wiring 91 is limited to the voltage obtained by adding the forward voltage Vf1 of the diode D1 to the voltage Vc1 of the capacitor C1. Since forward voltage Vf1 of the diode D1 can be generally kept less than several tens of volts, and the voltage of Vc1 of the capacitor C1 can also be suppressed by sufficiently increasing a capacity of the capacitor C1, it is possible to suppress the voltage Vin of the input wiring 91 to a voltage lower than the charge voltages of the storage capacitor Cs of the surge source 7, and the internal circuit 5 can be protected.

Since the surge is not always applied only once, it is necessary to promptly discharge the charge of the capacitor C1 charged by the surge. This is achieved by being discharged to the wiring 94 of the internal power supply through the protection resistor R1.

[Operation of protection circuit 4 when negative voltages surge is applied]

In cases where the surge of negative voltage is applied to the input terminal 81, a potential Vin of the input wiring 91 becomes lower than a GND potential, the diode D2 is biased in the forward direction, surge current flows in the forward direction, and this surge current flows out of the capacitor C2.

At this time, the potential Vin of the input wiring 91 is limited to the voltage obtained by adding the forward voltage Vf2 of the diode D2 to the voltage Vc2 of the capacitor C2. As a result, as with the application of the positive voltage surge, it is possible to suppress the voltage Vin of the input wiring 91 to a voltage lower than the charge voltage of storage capacitor Cs of the surge source 7, and the internal circuit 5 can be protected. The electric charge of the capacitor C2 charged by the surge is discharged by the GND wiring 93 through the protection resistor R2.

The above is the operation of the protection circuit 4 at the time of the surge application.

[Constraint on capacity of capacitors C1 and C2]

In the above description, it is stated that the capacity of the capacitors C1 and C2 needs to be large enough. The constraint on this capacitance value will be described.

With regard to the capacitance values of the capacitors C1 and C2, when the maximum charge amount of a surge that is supposed to be applied to the electronic control device is Qs [C], and out of the withstand voltages of the internal circuit, and the input terminal for the sensor or the like, and the withstand voltages of the diode D1 and D2, the lower one is Vmax, a capacity Cs of the capacitors needs to satisfy a inequality [Cs≥Qs/Vmax].

The inequality should apply due to the following reason. The capacitor C1 or C2 is charged by the surge application. If the charge voltages become large, the voltage of the input terminal 81 will also increase accordingly, and if either one of the withstand voltages of the internal circuit, and the input terminal 81 for the sensor or the like, and the withstand voltage of the reversely biased diode (D2 at the time of application of a positive voltage surge or D1 at the time of applying a negative voltage surge) is exceeded, they may be destroyed.

To give a specific numerical value, the charge amount Qs of the surge is about 2.64 [nC], which is the product of the capacitance value (330 pF) of the storage capacitor Cs and the charge voltage (8 kV) under the application condition of static electricity as shown in FIG. 7. The withstand voltages of the internal circuit, and the input terminal for the sensor or the like, and the withstand voltage of the PN junction depend on a sensor and an internal circuit to be used, components used for the protection circuit, or a semiconductor process. Since a special process is needed for securing a withstand voltage larger than 100 V and the cost is high particularly in a semiconductor, Vmax is 100 [V] in this example.

At this time, it can be understood that the capacitance value Cs of the capacitors C1 and C2 needs to be 0.264 [μF] or more from the following calculation formula.

$$[Cs \geq Qs/Vmax = 2.64 \ [nC]/100 \ [V] = 0.0264 \ [\mu F]]$$

[Operation of protection circuit 4 at the time of battery connection abnormality]

Next, the operation of the protection circuit 4 will be described when the battery 3 is reversely connected in polarity as battery connection abnormality. When the battery 3 is reversely connected in polarity, a Vb power supply serves as reversed polarity (negative voltage) relative to a GND potential, and unusual current tends to flow toward the Vb power supply wiring 92 from the GND wiring 93. Thus, it is necessary to suppress it to a sufficiently small value.

Here, unusual current in a path which passes through the power supply circuit 6 can be cut off within the power supply circuit 6. With regard to a path from the GND wiring 93 to the input terminal 81 through the internal circuit 5, since the internal circuit 5 has generally high impedance at its input, unusual current can be cut off here.

The remaining paths lead to the input terminal 81 through the protection circuit 4 from the GND wiring 93, and one of the remaining paths is a path 1 which passes through the capacitor C2 and the diode D2, and the other is a path 2 which passes through the protection resistor R2 and the diode D2. Here, with regard to the path 1, since the capacitor C2 does not pass direct current, unusual current can be cut off. With regard to the path 2, unusual current can be suppressed to a low value by setting a resistance value Rp of the protection resistor R2 to a sufficiently high value.

From the above, it is possible to suppress unusual current due to battery connection abnormality in all possible paths to a sufficiently small value, and to protect the sensor or the like 2 and the protection circuit 4 itself.

[Constraint on resistance value of protection resistor R2]

In the above description, it is stated that the resistance value Rp of the protection resistor R2 needs to be large enough. The constraint on this resistance value will be described.

A resistance value Rp of the protection resistor R2 needs to satisfy the inequality, $[Rp \geq Vb \times Vb/P]$, where battery voltage is Vb and an allowable dissipation of a package including the protection resistor R2 is P. This is because when the resistance value Rp is small, unusual current flowing through the protection resistor R2 increases and when the allowable dissipation P of the package is exceeded, the protection resistor R2 is damaged due to burning or others, and thus the protection ability against a surge to be applied in another occasion may be lost.

To give a specific numerical value, battery voltage Vb turns into a comparatively high voltage, when battery 3 is charged by an alternator, and the voltage Vb is generally around 14 [V]s. Although an allowable dissipation P of a package including the protection resistor R2 depends on a package to be used, when the allowable dissipation P greatly exceeds 1 [W], generally special heat dissipation structure is needed, and the cost is high. Thus, the allowable dissipation P is set to 1 [W] in this example.

At this time, it can be understood that a resistance value Rp of the protection resistor R2 needs to be 196 [$\Omega$] or more from the following calculation formula.

$$[Rp \geq Vb \times Vb/P = 14 \ [V] \times 14 \ [V]/1 \ [W] = 196 \ [\Omega]]$$

[Other Constraint on resistance value of protection resistor R2]

Incidentally, the protection resistor R2 has constraints with regard to a resistance value other than the above constraint. For example, there is an important constraint on a resistance value of the protection resistor R2 is such that unusual current can be suppressed to a value smaller than the current value which is allowed to flow into the sensor or the like 2 from the input wiring 91. However, this constraint largely depends on the specification of the sensor or the like 2 to be selected. Thus, it is difficult to define he value in general, and the values will not be calculated here.

The above is an operation of the protection circuit 4 at the time of surge application and battery connection abnormality in the electronic control device 1 in this embodiment.

[Mounting Method of Protection Circuit 4 on Integrated Circuit (Bulk Silicon)]

Next, for the miniaturization of the electronic control device 1, a mounting method for integrating a part of the protection circuit 4 into a bulk silicon chip will be described. The integration is made for elements shown inside of the broken line indicated by 41 in FIG. 6, i.e., the diodes D1 and D2, and the protection resistors R1 and R2. Hereinafter, the protection circuit in the dashed line of 41 is referred to as an integrated protection circuit 41. Since C1 and C2 are not suitable for mounting on an integrated circuit as described in the "Problem to be Solved by the Invention", they are not included as the obj ect of integrated protection circuit 41 here.

First, a section structure of the integrated protection circuit 41 in this mounting method will be described with reference to FIG. 8. FIG. 8 is a view showing the section structure of the integrated protection circuit 41 in this mounting method.

The integrated protection circuit 41 is roughly divided into a device layer 42 on which a semiconductor device is formed, and a wiring layer 43, and the diodes D1 and D2 are formed in the device layer 42, and the protection resistors R1 and R2, and the wiring which connects elements inside and outside of the integrated protection circuit 41 are formed in the wiring layer 43.

The structure of the device layer 42 will be described in detail. First, the entire device layer 42 includes a p-sub (p-type substrate) region 421 of a p-type semiconductor as a base. An n type region 422 is formed in the p-sub region 421, a p type region 423 is further formed in the n type region 422, and the diode D1 is constituted by a PN junction at the interface of the n type region 422, and the p type region 423. An n type region 424 is formed in another part, and a p type region 425 is further formed in the region 424, and an n type region 426 is formed in the region 425, and a PN junction at the interface of the p type region 425 and the n type region 426 constitutes diode D2.

In the wiring layer 43, the protection resistors R1 and R2 are formed using in polysilicon wiring, and a terminal 431 for connecting with the outside of the integrated protection circuit 41 is formed.

[Separation of GND wiring and protection element by separation layer using PN junction]

These elements are connected in the wiring layer 43 in the basically same manner as the circuit block diagram of FIG. 6, and there are two additional connections. The first additional connection is that the p-sub region 421 is connected to the GND wiring 93 at the wiring layer. This is because if the p-sub region 421 is connected with no potential, this may have a bad influence through a stray capacitance or a parasite diode between the surrounding element or wiring, and it is necessary to fix the potential.

The second additional connection is that the n type region 424 is connected to a wiring 95. Accordingly, the n type region 424 is biased to an internal power supply potential Vcc through the protection resistor R1. Both PN junction 4251 between the n type region 424 and the p-sub region 421, and PN junction 4252 between the n type region 424 and the p type region 425 are reversely biased, and this configuration thus functions as a separation layer which separates the p-sub region 421 and the diode D2.

In cases where this separation layer does not exist, the p type region 425 which is an anode of the diode D2 is electrically connected with the GND wiring 93 through the p-sub region 421, and thus, unusual current cannot be suppressed by the protection resistor R2 at the time of battery connection abnormality. With this separation layer, the insulation between the diode D2 and the GND wiring 93 can be secured, and the protection resistor R2 can serve effectively.

The above is a mounting method for integrating the integrated protection circuit 41 onto a bulk silicon chip.

[Another Mounting Method of Protection Circuit 4 on Integrated Circuit (SOI)]

Next, as an alternative method of integration of the integrated protection circuit 41, a mounting method for integration on a chip of SOI (silicon on insulator) will be described.

First, a section structure of the integrated protection circuit 41 in this mounting method will be described with reference to FIG. 9. FIG. 9 is a view showing the section structure of the integrated protection circuit 41 in this mounting method.

The integrated protection circuit 41 is roughly divided into a substrate layer 44, a BOX layer 45, a SOI layer 46, and a wiring layer 43. Diodes D1 and D2 are formed in the SOI layer 46, and the wiring which connects the protection resistors R1 and R2 and elements inside and outside of the integrated protection circuit 41 are formed in the wiring layer 43.

While the substrate layer 44 is made of silicon and serves as a base for upper layers, neither a circuit element nor wiring is formed in this circuit. The BOX layer 45 is also called as an oxide film layer, and made of silicon oxide film. This layer has the role of electrically insulating the substrate layer 42 and the SOI layer 46, which is disposed above the substrate layer 42, and the presence of this BOX layer 45 is a feature of the SOI chip. The SOI layer 46 is made of silicon, corresponds to the device layer 42 at the time of mounting with bulk silicon, and is a layer on which a semiconductor device is formed. The wiring layer 43 has the same configuration as the wiring layer 43 at the time of mounting with the bulk silicon.

The structure of the SOI layer 46 will be described in detail. First, the entire SOI layer 46 is based on a p type semiconductor region 461. An n type region 462, which is sandwiched by grooved oxide 469, is formed on the region 461, a p type region 463 is further formed in the region 462, and a diode D1 is constituted by a PN junction at the interface of the p type region 463 and the n type region 462. Similarly in another part, a p type region 465, which is sandwiched by grooved oxide 469, is formed on the region 461, a n type region 466 is further formed in the region 465, and a diode D2 is constituted by a PN junction at the interface between the p type region 465 and the n type region 466.

These elements are connected in basically the same manner as the circuit block diagram of FIG. 6 within the wiring layer 43. However, as an additional connection, the p type semiconductor region 461 and the substrate layer 42 are connected to the GND wiring 93 for fixation of potential.

[Separation of GND wiring and protection element by BOX layer 45 and grooved oxide 469]

In this mounting method, the insulation between the diode D2 and the GND wiring 93 is achieved by the BOX layer 45 and the grooved oxide 469. Compared with the insulation method with the reversely biased PN junction at the time of mounting with bulk silicon, this mounting method can ensure higher insulation performance such as smaller parasitic capacitance and less possibility of adverse effect by the parasitic element.

The above is the mounting method for integrating the integrated protection circuit 41 onto a SOI chip.

(Second embodiment)

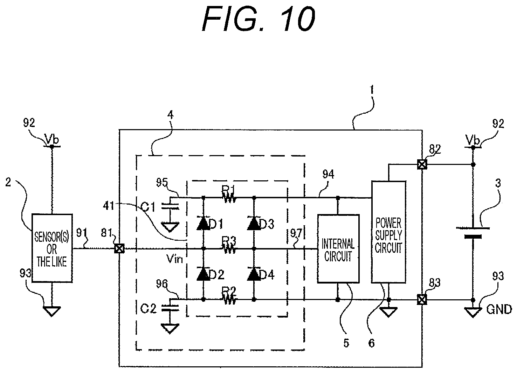

Next, the electronic control device according to the second embodiment of the present invention is described from the aspect of difference from the configuration in the first embodiment. FIG. 10 is a circuit block diagram showing a configuration of an electronic control device 1 according to this embodiment.

Although an electronic control device 1 in this embodiment has basically the same configuration as the electronic control device 1 in the first embodiment, an additional circuit is formed in a protection circuit 4, in particular in an integrated protection circuit 41. That is, a protection resistor R3 and diodes D3 and D4 are formed backward of diodes the D1 and D2 and the protection resistors R1 and R2.

[Operation of protection circuit 4 at the time of normal operation]

First, operation of protection circuit 4 at the time of normal operation will be described. The operation in the normal operation in the present embodiment is basically the same as that in the first embodiment. That is, the protection circuit 4 does not perform positive operation, but passes a signal from the input terminal 81, and transmits it to the internal circuit 5. Specifically, since a potential Vin of the input wiring 91 is between a GND potential and a potential Vcc of the internal power supply, the diodes D3 and D4 in addition to the diodes D1 and D2 are reversely biased, current does not flow during normal operation and an input signal is not interfered.

[Operation of protection circuit 4 when surge is applied]

Even when a surge is applied, components common to those in the first embodiment, i.e., the diodes D1 and D2, the protection resistors R1 and R2, and the capacitors C1 and C2 perform the same operation as those in the first embodiment. Difference is that the protection resistor R3, and the diodes D3 and D4, which are added, perform an additional protection function.

That is, as described in the first embodiment, the potential Vin of the input wiring 91 when the surge is applied can be suppressed to several tens of volts or less by the diode D1 or D2, but according to an operation described below in this embodiment, a potential of an input wiring 97 of the internal circuit 5 can be suppressed to a further lower voltage.

That is, when a surge of a positive voltage is applied, the diode D3 is biased in the forward direction, and surge current flows into an internal power supply wiring 94 through the protection resistor R3. At this time, voltage can drop in the protection resistor R3, and the potential of the input wiring 97 can be lowered as compared with the potential of the input wiring 91.

When a surge of a negative voltage is applied, the diode D4 is biased in the forward direction, and surge current flows from the GND wiring 93 through the protection resistor R3. At this time, voltage can drop in the protection resistor R3, and a potential of the input wiring 97 can be raised (the difference from the GND potential can be reduced) as compared with the potential of the input wiring 91.

The above is an operation of the protection circuit 4 in this embodiment, and the internal circuit 5 can be more effectively protected by this operation.

Although the protection circuit 4 in the first and second embodiments describes the case where the number of the input terminals 81 is one for simplicity of description, the case where the number of the input terminals is two or more can also apply. In this case, the capacitors C1 and C2 and the protection resistors R1 and R2 may be shared for each input terminal.

Various kinds of modifications as described above may be applied independently, or in any combination.

Reference Signs List

1: electronic control device, 2: sensor(s) or the like, 3: battery, 4: protection circuit, 5: internal circuit, 6: power supply circuit, 7: surge source
41: integrated protection circuit, 42: device layer, 43: wiring layer, 44: substrate layer, 45: box layer, 46: SOI layer
D1, D2, D3, D4: diode, R1, R2, R3: protection resistor, C1, C2: capacitor
81: input terminal, 91: input wiring, 92: Vb power supply wiring,
93: GND wiring, 94: internal power supply wiring

**Claims**

1. An electronic control device comprising:

   an input terminal connectable with an external sensor or an external switch; and
   a power supply wiring and a GND wiring used for supplying power to an internal circuit,
   wherein a protection element including a PN junction is connected between the input terminal and the power supply wiring or the GND wiring, and
   a protection resistor is further connected in series between the protection element and the power supply wiring or the GND wiring.

2. The electronic control device according to claim 1, wherein a diode is used as the protection element including the PN junction.

3. The electronic control device according to claim 1, wherein when a power supply voltage supplied to the electronic control device is Vb and an allowable dissipation of a package including the protection resistor is P, a resistance value Rp of the protection resistor satisfies an inequality [$Rp \geq Vb \times Vb/P$].

4. The electronic control device according to claim 1, wherein a resistance value Rp of the protection resistor is 196 [$\Omega$] or more.

5. The electronic control device according to claim 1, wherein a capacitor is connected between a wiring between the protection element including the PN junction and the protection resistor, and the power supply wiring or the GND wiring.

6. The electronic control device according to claim 5, wherein when a maximum charge amount of a surge that is supposed to be applied to the electronic control device is Qs [C], and out of withstand voltages of an internal circuit, and an input terminal for a sensor or the like, and a withstand voltage of the PN junction, the lower one is Vmax, a capacity Cs of the capacitor satisfies an inequality [$Cs \geq Qs/Vmax$].

7. The electronic control device according to claim 5, wherein the capacity Cs of the capacitor is 0.0264 $\mu$F or more.

8. The electronic control device according to claim 1, wherein the protection element including the PN junction is integrated on a silicon chip.

9. The electronic control device according to claim 8, wherein a separation layer constituted by a PN junction is disposed between the protection element including the PN junction and a substrate of the silicon chip.

10. The electronic control device according to claim 9, wherein the separation layer has a SOI (silicon on insulator) structure.

# FIG. 1

# FIG. 2

# FIG. 3

## FIG. 4

## FIG. 5

## FIG. 6

# FIG. 7

# FIG. 8

# FIG. 9

# FIG. 10

## INTERNATIONAL SEARCH REPORT

| International application No. |
| --- |
| PCT/JP2015/072440 |

A.   CLASSIFICATION OF SUBJECT MATTER
*B60R16/02*(2006.01)i, *H01L21/822*(2006.01)i, *H01L27/04*(2006.01)i

According to International Patent Classification (IPC) or to both national classification and IPC

B.   FIELDS SEARCHED

Minimum documentation searched (classification system followed by classification symbols)
B60R16/02, H01L21/822, H01L27/04

Documentation searched other than minimum documentation to the extent that such documents are included in the fields searched
Jitsuyo Shinan Koho          1922-1996   Jitsuyo Shinan Toroku Koho   1996-2015
Kokai Jitsuyo Shinan Koho    1971-2015   Toroku Jitsuyo Shinan Koho   1994-2015

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2-292856 A  (Sony Corp.),<br>04 December 1990 (04.12.1990),<br>page 2, lower right column, lines 9 to 15; fig. 1<br>(Family: none) | 1,2,8<br>3,4,9,10<br>5-7 |
| Y | JP 11-103021 A  (Seiko Instruments Inc.),<br>13 April 1999 (13.04.1999),<br>paragraph [0013]<br>& US 6091592 A<br>column 3, lines 3 to 9<br>& TW 461076 B          & HK 1019520 A<br>& CN 1213879 A | 3,4 |

☒   Further documents are listed in the continuation of Box C.      ☐   See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    10 November 2015 (10.11.15) | Date of mailing of the international search report<br>    24 November 2015 (24.11.15) |
| --- | --- |
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (July 2009)

## INTERNATIONAL SEARCH REPORT

International application No.

PCT/JP2015/072440

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2006-517350 A (Freescale Semiconductor Inc.), 20 July 2006 (20.07.2006), fig. 4 & US 2004/0155300 A1 fig. 4 & WO 2004/073023 A2  & EP 1595277 A2 & KR 10-2005-0107753 A  & CN 1748309 A & TW 200417022 A | 9 |
| Y | JP 2000-50486 A (Denso Corp.), 18 February 2000 (18.02.2000), fig. 1 (Family: none) | 10 |
| A | JP 2-159757 A (NEC Corp.), 19 June 1990 (19.06.1990), (Family: none) | 1-10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 20133072076 A